# EUROPEAN PATENT APPLICATION

(11) **EP 2 282 342 A1**
(43) Date of publication of application: **09.02.2011**
(21) Application number: 09754459.7
(22) Date of filing: 29.05.2009
(51) Int. Cl.: H01L 27/14, H01L 31/02

(54) **LIGHT-RECEIVING DEVICE AND PRODUCTION THEROF**

(30) Priority: 30.05.2008 JP 2008143199; 02.12.2008 JP 2008307046
(71) Applicant: Sumitomo Bakelite Co., Ltd., Shinagawa-ku Tokyo 140-0002 (JP)
(72) Inventor: SHIRAISHI, Fumihiro, Tokyo 140-0002 (JP); TAKAHASHI, Toyosei, Tokyo 140-0002 (JP); SATO, Toshihiro, Tokyo 140-0002 (JP)
(74) Representative: Müller, Christian Stefan Gerd
(86) International application number: PCT/JP2009/002382
(87) International publication number: WO 2009/144951

(57) **Abstract**

There is provided a device including at least one light-receiving unit 11, a base substrate 12A provided with the light-receiving unit 11, a transparent base substrate 13A disposed facing the base substrate 12A and the light-receiving unit 11, and a frame member 14A disposed around the light-receiving unit 11 between the base substrate 12A and the transparent substrate 13A. The frame member 14A consists of a cured resin composition. The resin composition contains an alkali-soluble resin, a photopolymerizable resin and an inorganic filler in 9 % or less by weight. The photopolymerizable resin contains an acrylic polyfunctional monomer. The frame member 14A has a moisture permeability of 12 [g/m²·24h] or more and an elastic modulus of 100 Pa or more at 80 degrees C.

## Description

### TECHNICAL FIELD

The present invention relates to a light-receiving device and a method of manufacturing the same.

### BACKGROUND ART

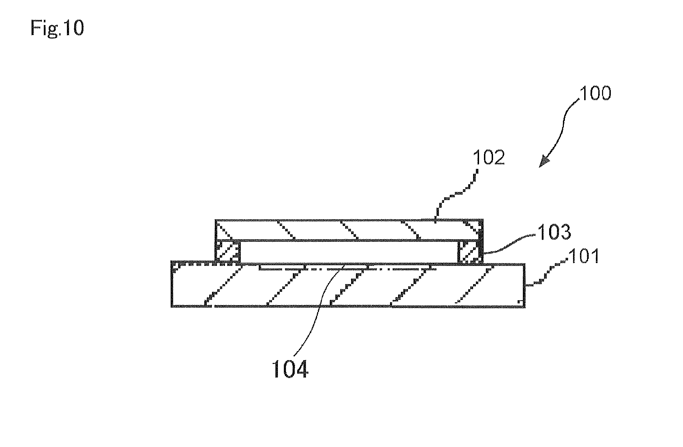

Conventionally, it is known that a solid-state image sensing device employing a hollow package as shown by Fig. 10. FIG. 10 is a cross-sectional view in a direction perpendicular to the substrate surface of a base substrate 101 and a transparent substrate 102. Such a solid-state image sensing device has a base substrate 101 on which a microlens array is formed, a transparent substrate 102, a light-receiving part 104 consisting of the microlens array and a frame member 103 formed around the light-receiving unit 104.

As a process for such a solid-state image sensing device, photolithography technique such as exposure and development is used. Patent Document 1 shows an example of the technique. According to the technique of Patent Document 1, the frame member 103 consists of a resin composition containing a photocurable resin. Thus, depending on the properties of the photocurable resin contained in the frame member 103, the base substrate 101 and the transparent substrate 102 can be patterned to form a frame member 103 having a precise and fine pattern.

In the solid-state image sensing device as described above, the frame member 103 is generally formed from a resin composition containing a filler to prevent dew condensation in the transparent substrate 102 and the base substrate 101. Furthermore, generally a thermosetting resin is added to a resin composition to improve adhesiveness between the frame member 103 and the transparent substrate 102 and to improve device reliability.
Patent Document 1: Japanese Unexamined Patent Application Publication No. 2004-296453.

### DISCROSURE OF THE INVENTION

The present inventors have, however, found that in the prior art described in the above reference, further improvement in device reliability is difficult due to (i) insufficient strength of the frame member and (ii) a residue in an inner space which leads to yield reduction.

First, the inventors' findings have shown that reduction in strength of the frame member is caused by undercut occurring in the frame member. Undercut is thought to be caused by permeation of a developer into the frame member which occurs due to insufficient curing in the side of the base substrate or the transparent substrate in a thickness direction of the frame member. Significant undercut sometimes led to detachment of the frame member. Furthermore, significant undercut led to difficulty in improvement in resolution.

The inventors have found that the residue in the inner space after exposure and development contains the inorganic filler. This would be because the inorganic filler is released from the frame member during development and left as foreign materials. The foreign materials adhere to the transparent substrate and the base substrate, leading to adverse affect to imaging properties and to reduction in a yield.

Then it has been found that forming a frame member from a resin composition free from an inorganic filler can reduce foreign materials generated in the inner space.

In addition, it has been found that a frame member free from an inorganic filler can reduce undercut in the frame member. This would be because a frame member free from an inorganic filler leads to improved light permeability and thus reinforced curing of the photocurable resin. It would lead to improved strength of the frame member and elimination of permeation by a developer.

Meanwhile, it has been found that a frame member without an inorganic filler leads to reduction in shape retainability of the hollow package after exposure.

The present invention has been in view of the above situation, and an objective thereof is to maintain shape retainability in a light-receiving device employing a hollow package while a content of an inorganic filler in a frame member is reduced to a certain level or less for minimizing foreign materials generated in an inner space and undercut in the frame member.

According to the present invention, there is provided a light-receiving device comprising:
at least one light-receiving unit;
a base substrate provided with said light-receiving unit;
a transparent substrate disposed facing said base substrate and said light-receiving unit; and
a frame member disposed around said light-receiving unit between said base substrate and said transparent substrate; wherein said frame member consists of a cured resin composition;
said resin composition contains
   an alkali-soluble resin,
   a photopolymerizable resin, and
   an inorganic filler of 9 % or less by weight;
said photopolymerizable resin includes an acrylic polyfunctional monomer;
said frame member meets the following conditions (a) and (b) :
   (a) said frame member has a moisture permeability of 12 [g/m² · 24h] or more as determined in accordance with JIS 20208 Method B; and
   (b) said frame member has an elastic modulus of 100 Pa or more at 80 degrees C after exposure at all wavelengths by a mercury lamp until an accumulated exposure amount is 700 mJ/cm² with an i-line (365 nm) beam.

According to the present invention, there is also provided a method for manufacturing a light-receiving device, comprising:
laminating an adhesive film composed of an electron-beam curable resin composition on a base substrate provided with at least one light-receiving part or a transparent substrate to cover said base substrate or said transparent substrate;
selectively irradiating said adhesive film with an electron beam to leave said adhesive film in a region surrounding at least said light-receiving part on said base substrate or a region surrounding each region covering said light-receiving unit in said transparent substrate when said transparent substrate is disposed facing said base substrate;
disposing said base substrate and said transparent substrate facing each other to bond via said adhesive film, and
providing a light-receiving device having said base substrate, said transparent substrate, and a frame member which is composed of said adhesive film to be disposed around said light-receiving unit while being provided between said base substrate and said transparent substrate;
   wherein
   said resin composition contains
   an alkali-soluble resin,
   a photopolymerizable resin, and
   an inorganic filler of 9 % or less by weight;
   said photopolymerizable resin includes an acrylic polyfunctional monomer;
   said frame member meets the following conditions (a) and (b) :
   (a) said frame member has a moisture permeability of 12 [g/m²·24h] or more as determined in accordance with JIS Z0208 Method B; and
   (b) said frame member has an elastic modulus of 100 Pa or more at 80 degrees C after exposure at all wavelengths by a mercury lamp until an accumulated exposure amount is 700 mJ/cm² with an i-line (365 nm) beam.

According to this invention, foreign materials generated in the inside of the hollow package can be reduced by adjusting the amount of an inorganic filler to 9 % or less by weight of the resin composition constituting the frame member. Furthermore, 9 % or less by weight of the inorganic filler in the resin composition can improve light transmission in the frame member and improve curing of the resin composition. Thus, it can prevent a developer from flowing out to the frame member to prevent generating undercut. Furthermore, by using a photopolymerizable resin containing an alkali-soluble resin and an acrylic polyfunctional monomer, a moisture permeability of the frame member can be adjusted to 12 [g/m²·24h] or more, and an elastic modulus at 80 degrees C to 100 Pa ormore after exposure at all wavelengths by a mercury lamp until an accumulated exposure amount is 700 mJ/cm² with an i-line (365 nm) beam. Therefore, the frame member of the present invention is also excellent in strength and moisture permeability. As described above, the present invention allows for improving reliability by maintaining shape retainability of the light-receiving device while preventing dew condensation.

The present invention can employ the following embodiments.
(i) The photopolymerizable resin includes an epoxy vinyl ester resin.
(ii) A weight content of the epoxy vinyl ester resin is 3 to 30 % of the resin composition.
(iii) The acrylic polyfunctional monomer is a (meth) acrylate compound.
(iv) The acrylic polyfunctional monomer is a trifunctional (meth) acrylate compound or tetrafunctional (meth) acrylate compound.
(v) The acrylic polyfunctional monomer is a trimethylolpropane tri(meth)acrylate.
(vi) A weight content of the acrylic polyfunctional monomer is 1 to 50 % of the resin composition.
(vii) The alkali-soluble resin is a (meth)acrylic-modified novolac resin.
(viii) A weight content of the alkali-soluble resin is 50 to 95% of the resin composition.

Various components of the present invention are not necessarily independent of each other, but a plurality of components may be formed as a single member; a single component may be constituted by a plurality of members; a certain component may be a part of another component; or a part of a certain component may overlap a part of another component.

Although there have been sequentially described a plurality of steps in the method for manufacturing a semiconductor device of the present invention, the order described does not limit the order of conducting the plurality of steps. Therefore, in conducting the method for manufacturing a semiconductor device of the present invention, the order of the plurality of steps can be varied as long as such variation does not deteriorate the resultant device.

According to the present invention, in a light-receiving device employing a hollow package, undercut and residue after exposure can be reduced while shape retainability and moisture permeability are improved.

### BRIEF DESCRIPTION OF THE DRAWINGS

The foregoing and other objects, features, and advantages of the invention will be further apparent from the following preferred embodiments and the accompanying drawings in which:

FIG. 1 is a cross-sectional view schematically showing a light-receiving device according to an embodiment of the present invention;
FIG. 2 illustrates a process for manufacturing a light-receiving device according to an embodiment of the present invention;
FIG. 3 is a plan view illustrating the state that an adhesive film is selectively left on a base substrate;
FIG. 4 is a cross-sectional view showing a light-receiving device according to a variation of the present invention;
FIG. 5 is a cross-sectional view showing a light-receiving device according to a variation of the present invention;
FIG. 6 shows the results of an example of the present invention and comparative examples;
FIG. 7 is a graph showing the results of an example of the present invention and comparative examples;
FIG. 8 shows the results of comparative examples of the present invention;
FIG. 9 shows the results of comparative examples of the present invention; and
FIG. 10 shows a conventional light-receiving device.

### BEST MODE FOR CARRYING OUT THE INVENTION

An embodiment of the present invention will be described with reference to the drawings. In all of drawings, equivalent components will be denoted by similar symbols, and the description thereof will be appropriately not repeated.

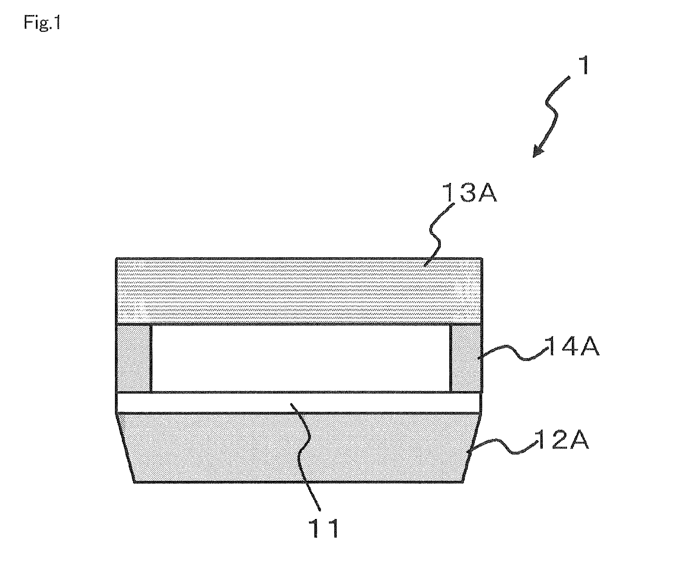

A light-receiving device of the present embodiment will be described with reference to FIGs. 1 to 3. A light-receiving device 1 according to the present embodiment includes a plurality of light-receiving units 11, a base substrate 12A provided with the light-receiving units 11, a transparent substrate 13A disposed facing the base substrate 12A and the light-receiving units 11, and a frame member 14A disposed around the light-receiving units 11 between the base substrate 12A and the transparent substrate 13A. The frame member 14A consists of a cured resin composition. This resin composition contains an alkali-soluble resin, a photopolymerizable resin, and an inorganic filler in 9 % or less by weight. The photopolymerizable resin includes an acrylic polyfunctional monomer. The frame member 14A meets the following conditions (a) and (b).
(a) the frame member 14A has a moisture permeability of 12 [g/m²·24h] or more as determined in accordance with JIS Z0208 Method B; and
(b) the frame member 14A has an elastic modulus of 100 Pa or more at 80 degrees C after exposure at all wavelengths by a mercury lamp until an accumulated exposure amount is 700 mJ/cm² with an i-line (365 nm) beam.

There will be detailed a configuration of the light-receiving device 1 and a method for manufacturing the light-receiving device 1. FIG. 1 is a cross-sectional view in a direction perpendicular to the substrate surface of the base substrate 12A and the transparent substrate 13A. The light-receiving device 1 is used as a solid-state image sensing device.

The light-receiving device 1 has a base substrate 12A, a transparent substrate 13A, a light-receiving unit 11 consisting of light-receiving elements, and a frame member 14A formed around the light-receiving unit 11 as shown in the cross-sectional view of FIG. 1.

The base substrate 12A is, for example, a semiconductor substrate, and a microlens array is formed on this base substrate 12A.

The transparent substrate 13A is disposed facing the base substrate 12A, and has planar dimensions substantially equal to planar dimensions of the base substrate 12A. The transparent substrate 13A is, for example, an acrylic-resin, polyethylene terephtalate resin (PET), glass substrate, or the like.

The frame member 14A directly adheres to the microlens array on the base substrate 12A and the transparent substrate 13A, bonding the base substrate 12A to the transparent substrate 13A. This frame member 14A is disposed around the center of the microlens array in the base substrate 12A, and the part of the microlens array, which is surrounded by the frame member 14A acts as the light-receiving unit 11.

On the lower surface of the light-receiving unit 11, that is, on the base substrate 12A, there is formed a photoelectric conversion part (not shown), where a light received by the light-receiving unit 11 is converted to an electric signal. Furthermore, in the light-receiving unit 11, a light-receiving element is formed, including a CCD (Charge Coupled Device) and a CMOS (Complementary Metal Oxide Semiconductor).

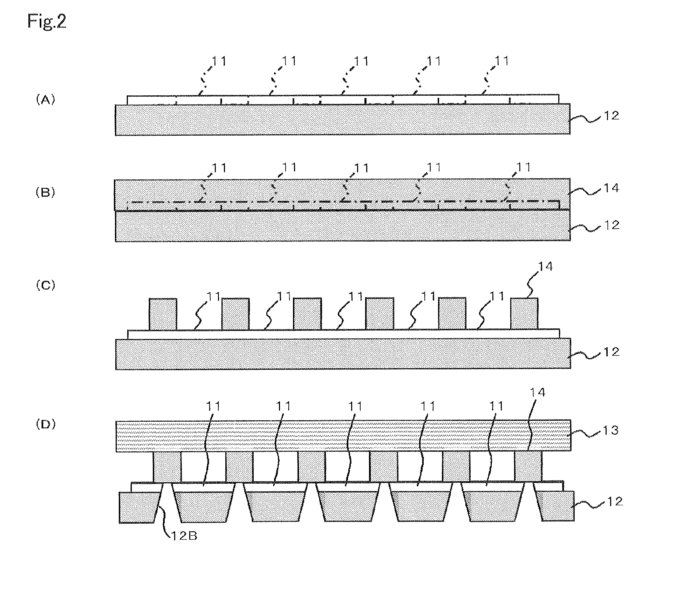

Next, there will be detailed a method for manufacturing such a light-receiving device 1 with reference to FIG. 2.

This manufacturing method includes the steps of laminating an adhesive film 14 composed of an electron-beam curable resin composition on a base substrate 12 provided with a plurality of light-receiving units 11 or a transparent substrate 13 to cover the base substrate 12 or the transparent substrate 13; the steps of selectively irradiating the adhesive film 14 with an electron beam to leave the adhesive film 14 in a region surrounding at least the light-receiving unit 11 on the base substrate 12 or a region surrounding each region covering the light-receiving unit 11 in the transparent substrate 13 when the transparent substrate 13 is disposed facing the base substrate 12; the steps of disposing the base substrate 12 and the transparent substrate 13 facing each other to bond via the adhesive film 14; and the steps of providing a light-receiving device having the base substrate 12, the transparent substrate 13, and a frame member 14A which is composed of the adhesive film 14A to be disposed around the light-receiving unit 11 while being providing between the base substrate 12 and the transparent substrate 13.

Here, an electron beam is a concept encompassing radiation with a wavelength of 150 nm to 700 nm, including, for example, near-ultraviolet and ultraviolet rays.

Specifically, first, a base substrate 12 with a plurality of light-receiving units 11 is prepared as shown in FIG. 2 (A). That is, a microlens array is formed on the base substrate 12. Furthermore, a light-receiving element is formed in the region to be the light-receiving unit 11.

Subsequently, an adhesive film 14 is laminated to cover the surface of the base substrate 12 (the surface provided with the light-receiving unit 11) as shown in FIG. 2(B).

Here, the adhesive film 14 is composed of a resin composition containing an alkali-soluble resin and a photopolymerizable resin.

The adhesive film 14 has a moisture permeability of preferably 12 [g/m²·24h] or more, particularly preferably 14 to 100 [g/m² · 24h] as determined in accordance with JIS Z0208 B. If it is less than the lower limit, dew condensation in, for example, the transparent substrate 13A in the light-receiving device 1 may be insufficiently prevented. If it is more than the upper limit, the adhesive film 14 may be less reliable in moisture absorption reflow. A moisture permeability can be evaluated using the adhesive film 14 with a thickness of 100 µm at 40 °C/90 % in accordance with a moisture-permeable cup method (JIS Z0208 Method B).

The adhesive film 14 has an elastic modulus at 80 degrees C of preferably 100 Pa or more, particularly preferably 500 to 30000 Pa after exposure at all wavelengths by a mercury lamp until an accumulated exposure amount is 700 mJ/cm² with an i-line (365 nm) beam. If it is less than the lower limit, shape retainability is deteriorated during laminating the base substrate and the transparent substrate. If it is more than the upper limit, lamination of the base substrate and the transparent substrate becomes difficult after patterning.

Examples of an alkali-soluble resin include (meth) acrylic-modified novolac resins such as (meth) acrylic-modified bis-A novolac resin; acrylic resins; copolymers of styrene and acrylic acid; hydroxystyrene polymers; polyvinylphenol; and poly α-methylvinylphenol, and among others, alkali-soluble novolac resins are preferable and (meth)acrylic-modified novolac resins are particularly preferable. Thus, a developer can be an aqueous alkaline solution which is environmentally less harmful rather than an organic solvent, and heat resistance can be maintained.

A content of the alkali-soluble resin is preferably, but not limited to, 50 to 95 % by weight of the resin composition constituting the adhesive film 14. If the content is less than the lower limit, compatibility may be less effectively improved while if it is more than the upper limit, development and resolution properties may be deteriorated.

An acrylic polyfunctional monomer is used as the photopolymerizable resin. A polyfunctional monomer is a monomer having three or more functional groups, and in the present embodiment, a tri- or tetra-functional acrylate ester compound can be particularly suitablyused. Abi- or less functional monomer is undesirable because the frame member 14A becomes too weak to retain the shape of the light-receiving device 1.

Specific examples of an acrylic polyfunctional monomer include trifunctional (meth)acrylates such as trimethylolpropane tri(meth)acrylate and pentaerythritol tri(meth)acrylate; tetrafunctional (meth)acrylates such as pentaerythritol tetra (meth) acrylate and di-trimethylolpropane tetra (meth) acrylate; and hexafunctional. (meth)acrylates such as di-pentaerythritol hexa(meth)acrylate. Among these, trifunctional (meth) acrylates or tetrafunctional (meth)acrylates are preferable. By the use of a trifunctional or tetrafunctional (meth)acrylate, strength of the frame member after exposure can be improved and shape retainability during laminating the base substrate and the transparent substrate can be improved.

A content of the acrylic polyfunctional monomer is preferably, but not limited to, 1 to 50 % by weight, particularly preferably 5 to 25 % by weight of the resin composition constituting the adhesive film 14. If it is less than the lower limit, strength of the frame member is deteriorated during laminating the base substrate and the transparent substrate. If it is more than the upper limit, adhesiveness between the base substrate and the transparent substrate may be deteriorated.

The photopolymerizable resin can contain an epoxy vinyl ester resin. The resin can be radically polymerized during exposure, improving strength of the frame member 14A. Meanwhile, during development, solubility to an alkali developer is improved, so that a residue after development can be reduced.

Examples of an epoxy vinyl ester resin include 2-hydroxy-3-phenoxypropyl acrylate, Epolite 40E methacryl adduct, Epolite 70P acrylic acid adduct, Epolite 200P acrylic acid adduct, Epolite 80MF acrylic acid adduct, Epolite 3002 methacrylic acid adduct, Epolite 3002 acrylic acid adduct, Epolite 1600 acrylic acid adduct, Bisphenol-A diglycidyl ether methacrylic acid adduct, Bisphenol-Adiglycidyl ether acrylic acid adduct, Epolite 200E acrylic acid adduct and Epolite 400E acrylic acid adduct.

A content of the epoxy vinyl ester resin is preferably, but not limited to, 3 to 30 % by weight of the resin composition constituting the adhesive film 14. If it is more than the upper limit, water-absorbing properties of the frame member are deteriorated, allowing dew condensation to easily occur. If it is less than the lower limit, the frame member may insoluble in an alkali developer to generate a residue after development. Particularly, the content is preferably within the range of 5 to 15 % by weight. Thus, after the application, foreign material remaining on the surfaces of the base substrate 12A and the transparent substrate 13A can be further reduced.

Furthermore, the adhesive film 14 preferably contains a photopolymerization initiator. Thus, the adhesive film 14 can be efficiently patterned by photopolymerization.

Examples of a photopolymerization initiator include benzophenone, acetophenone, benzoin, benzoin isobutyl ether, benzoin methyl benzoate, benzoin benzoic acid, benzoin methyl ether, benzylphinyl sulfide, benzil, dibenzyl and diacetyl.

A content of the photopolymerization initiator is preferably, but not limited to, 0.5 to 5 % by weight, particularly preferably 0. 8 to 3. 0 % by weight of the total resin composition. If the content is less than the lower limit, photopolymerizationmaynot be effectively initiated, while if it is more than the upper limit, reactivity may be excessively increased, leading to deterioration in a shelf life or resolution.

The adhesive film 14 preferably contains a thermosetting resin. Thus, even after exposure, development and patterning, the adhesive film can be adhesive. In other words, the adhesive film laminated can be exposed, developed and patterned, and then after an adhesive is applied to a given position, the product can be thermally compressed to bond the base substrate 12A and the transparent substrate 13A.

Examples of a thermosetting resin include novolac type phenolic resins such as phenol novolac resins, cresol novolac resins, bisphenol-A novolac resins; phenolic resins such as resol phenolic resins; bisphenol type epoxy resins such as bisphenol-A epoxy resin and bisphenol-F epoxy resin; novolac type epoxy resins such as novolac epoxy resin and cresol novolac epoxy resin; epoxy resins such as biphenyl type epoxy resins, stilbene type epoxy resins, triphenolmethane type epoxy resins, alkyl-modified triphenolmethane type epoxy resins, triazine-core containing epoxy resins and dicyclopentadiene-modified phenol type epoxy resins; triazine-ring containing resins such as urea resins and melamine resins; unsaturated polyester resins; bismaleimide resins; polyurethane resins; diallyl phthalate resins; silicone resins; benzoxazine-ring containing resins; cyanate ester resins; and epoxy-modified siloxanes, which can be used alone or in combination. Among these, epoxy resins are particularly preferable. Thus, heat resistance and adhesiveness can be further improved.

The epoxy resin is preferably a combination of an epoxy resin which is solid at room temperature (particularly, a bisphenol type epoxy resin) and an epoxy resin which is liquid at room temperature (particularly, a silicone-modified epoxy resin which is liquid at room temperature). Thus, there can be provided an adhesive film 14 which is excellent in both flexibility and resolution while maintaining heat resistance.

A content of the thermosetting resin is preferably, but not limited to, 10 to 40 % by weight, particularly preferably 15 to 35 % by weight to the total resin composition constituting the adhesive film 14. If the content is less than the lower limit, heat resistance may be less effectively improved, while if it is more than the upper limit, toughness of the adhesive film 14 may be less effectively improved.

The thermosetting resin can further contain a phenol novolac resin. By adding the phenol resin, developing properties can be improved. Furthermore, by adding both an epoxy resin and a phenol novolac resin, the epoxy resin can exhibit improved thermosetting properties and the frame member 14A can be further reinforced.

The adhesive film 14 may contain an inorganic filler, whose content is 9 % or less by weight to the total resin composition constituting the adhesive film 14. A content exceeding the upper limit is undesirable because foreign materials derived from the inorganic filler may adhere to the surface of the substrate or undercut may occur. In this embodiment, an inorganic filler may be absent.

Examples of an inorganic filler include fibrous fillers such as alumina fibers and glass fibers; needle fillers such as potassium titanate, wollastonite, aluminum borate, needle magnesium hydroxide and whisker; plate-like fillers such as talk, mica, sericite, glass flakes, flake graphite and plate-like calcium carbonate; spherical (granular) fillers such as calcium carbonate, silica, fused silica, calcined clay and uncalcined clay; and porous fillers such as zeolite and silica gel. These can be used alone or in combination of two or more. Among these, a porous filler is preferable.

An average particle size of the inorganic filler is preferably, but not limited to, 0.01 to 90 µm, particularly preferably 0.1 to 40 µm. If an average particle size is more than the upper limit, appearance and/or resolution of the film may be defective, while if it is less than the lower limit, adhesion may be defective during application under heating. An average particle size can be evaluated using, for example, a laser diffraction type size distribution measurement apparatus SALD-7000 (Shimadzu Corporation).

The inorganic filler may be a porous filler. When a porous filler is used as the inorganic filler, an average pore size of the porous filler is preferably 0.1 to 5 nm, particularly preferably 0.3 to 1 nm. If an average pore size is more than the upper limit, some of the resin component may enter the pores, leading to inhibition of the reaction, while if the size is less than the lower limit, water-absorbing ability may decrease to reduce moisture permeability of the adhesive film 1.4.

The resin composition constituting the adhesive film 14 can contain, as long as the objectives of the present invention are can be achieved, additives such as a plastic resin, a levelling agent, a defoaming agent and a coupling agent, in addition to the hardening resin and the filler described above.

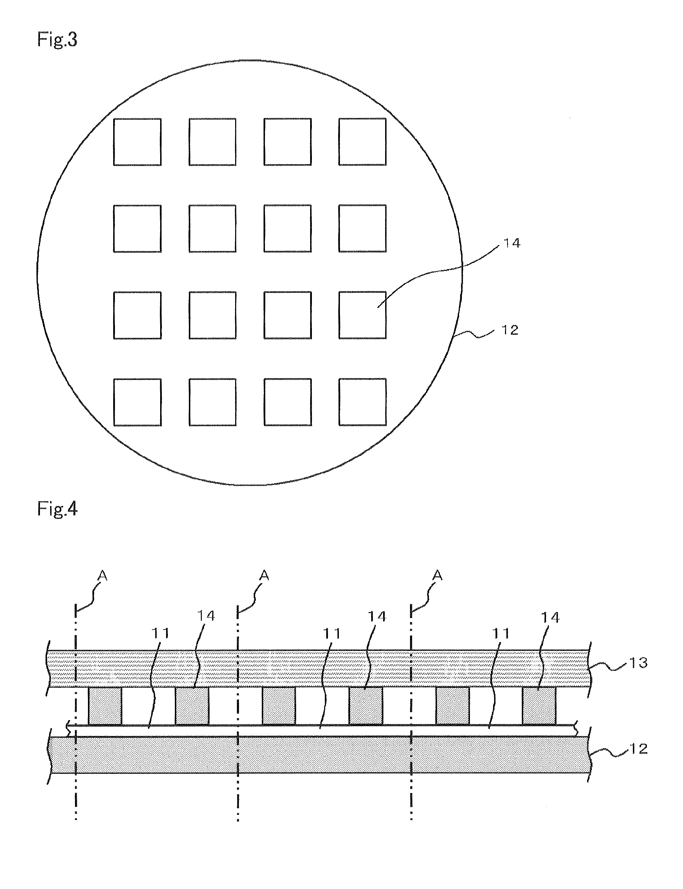

Next, using a photomask, the adhesive film 14 is selectively irradiated with electron beam (for example, ultraviolet rays). Thus, the irradiated part in the adhesive film 14 is light-cured. When the adhesive film 14 after exposure is developed by a developer (for example, an aqueous alkaline solution, an organic solvent or the like), the irradiated part is insoluble in the developer and remains. In the region on the base substrate 12 except the light-receiving units 11, the adhesive film 14 is left around the light-receiving units 11 (see FIG. 2(C)). Specifically, as shown in the plan view of FIG. 3, the adhesive film 14 is left in a lattice pattern.

Then, the transparent substrate 13 is placed on the adhesive film 14, and the base substrate 12 and the transparent substrate 13 are then bonded via the adhesive film 14. For example, the base substrate 12 and the transparent substrate 13 are compressed or compressed under heating to be bonded via the adhesive film 14.

Next, the base substrate 12 and the transparent substrate 13 which have been bonded are divided per a light-receiving unit (see FIG. 2(D)). Specifically, first, as water is supplied to the base substrate 12, the base substrate 12 is cut by a dicing saw to form a trench 12B. Then, a metal film (not shown) is formed by, for example, sputtering to cover the side surface of the trench 12B and the bottom surface of the base substrate 12.

Then, the product is cut by a dicing saw from the side of the transparent substrate 13, to divide the base substrate 12 and the transparent substrate 13 per a light-receiving unit 11. Again, the base substrate 12, the transparent substrate 13 and the adhesive film 14 are diced with supplying water.

The adhesive film 14 after exposure remains in the region except the light-receiving units 11, and therefore, when the base substrate 12 and the transparent substrate 13 are divided per a light-receiving unit, the adhesive film 14 is also diced.

By the above process, the resultant light-receiving device 1 is mounted on a supporting substrate (not shown) via, for example, a solder bump. On the supporting substrate, an interconnection is patterned, and the interconnection and the metal film (not shown) in the bottom of the base substrate 12 in the light-receiving device 1 are electrically connected via the solder bump.

There will be described the function effects of this embodiment. According to this embodiment, foreign materials in the inner space of the hollow package can be reduced by adjusting the content of the inorganic filler to 9 % or less by weight of the resin composition. Furthermore, with the the inorganic filler content of 9 % or less by weight in the resin composition, light permeability of the frame member 14A can be improved and hardening of the resin composition after exposure can be improved. Therefore, flowing of a developer into the frame member 14A during development can be prevented, thereby prevent the occurrence of undercut. Furthermore, according to the present embodiment, by using a photopolymerizable resin including an alkali-soluble resin and an acrylic polyfunctional monomer, a moisture permeability of the frame member as determined by JIS Z0208 Method B can be 12 [g/m²·24h] or more, and an elastic modulus of the frame member at 80 degrees C after exposure at all wavelengths by a mercury lamp until an accumulated exposure amount is 700 mJ/cm² with an i-line (365 nm) beam can be 100 Pa or more. Therefore, the frame member 14A is also excellent in strength and moisture permeability. As described above, according to the present embodiment, reliability can be improved by maintaining shape retainability of the light-receiving device 1 while preventing the occurrence of dew condensation.

In a conventional light-receiving device, strength of a frame member is maintained by adding an inorganic filler to an adhesive film. In contrast, in this embodiment, an acrylic polyfunctional monomer is used as a photopolymerizable resin. Therefore, a crosslink density can be improved by curing by light irradiation and thus strength of the framemember can be improved. Thus, without an inorganic filler, strength of the frame member can be maintained.

In a light-receiving device employing a hollow package, there has been a problem of generating dew condensation between the base substrate 12 and the transparent substrate 13A (inside). It is believed to be caused by moisture enclosed in the inner space during attaching the substrate and moisture entering the inside through the adhesive layer after the substrate attachment. There is, therefore, needed a frame member exhibiting excellent moisture permeability, which can prevent generating dew condensation.

In contrast, in the present embodiment, even a content of the inorganic filler is 9 % by weight or less of the resin composition can prevent the occurrence of dew condensation. Although the reason is not clearly understood, one reason would be that by adding an acrylic polyfunctional monomer, a cross-linked structure with a proper density can be formed by light irradiation. It would allow moisture permeability of the frame member 14A to be improved.

Furthermore, according to this embodiment, the inorganic filler is contained in 9 % or less by weight in the resin composition, so that foreign materials generated in the inner space can be reduced. Thus, foreign materials adhering to the base substrate 12A or the transparent substrate 13A can be reduced, resulting in minimizing adverse impact on a light-receiving element in the light-receiving unit 11.

Furthermore, since the inorganic filler is contained in 9 % or less by weight of the resin composition, light permeability of the adhesive film 14 can be improved. Thus, hardening of the resin composition can be improved, strength of the frame member 14A can be improved, and permeation of a developer during exposure can be reduced. Undercut in the frame member 14A can be, therefore, reduced.

Although there have been described embodiments of the present invention with reference to the drawings, these are provided for illustrative purposes and various configurations other than the above can be employed.

For example, in this embodiment, when the base substrate 12 and the transparent substrate 13 which have been bonded via the adhesive film 14 are diced per a light-receiving unit, the adhesive film 14 is also diced, but without being limited to it, the adhesive film 14 does not have to be diced.

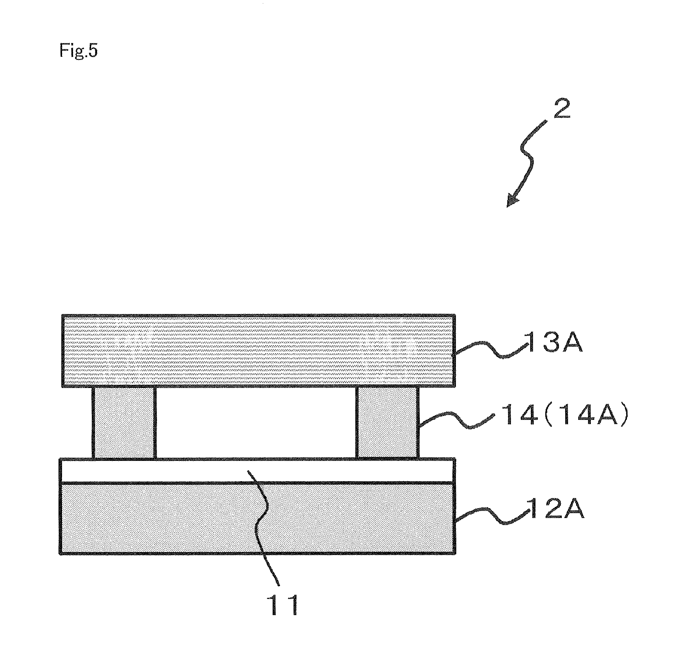

For example, as shown in FIG. 4, the base substrate 12 and the transparent substrate 13 may be diced on two-dot chain line A. Here, the light-receiving device 2 is formed such that as shown in FIG. 5, a distance between the edge of the base substrate 12A and the periphery of the frame member 14A is 20 % or less of the width dimension of the frame member 14A. Thus, the light-receiving device can be size-reduced.

The adhesive film 14 (the frame member 14A) and the base substrate 12 (the base substrate 12A) are bonded via a microlens array in the above embodiment, but without being limited to that, the adhesive film 14 (the frame member 14A) may be directly in contact with the base substrate 12 (the base substrate 12A).

When the adhesive film 14 is directly in contact with the base substrate 12, microlenses are formed not over the whole surface of the base substrate 12 but at certain intervals.

Furthermore, a mask film is formed by, for example, sputtering such that it covers the bottomof the base substrate 12 in the embodiment, but it is not limitative. For example, a hole can be formed in the base substrate 12 from the bottom side and the hole can be filled with a metal by, for example, plating. The photoelectric conversion unit can be electrically connected with the metal within the hole to transmit an electric signal to the supporting substrate.

Furthermore, in the embodiment, the adhesive film 14 is laminated on the base substrate 12 provided with a plurality of light-receiving units 11, but without being limited to that, the adhesive film 14 can be laminated on the surface of the transparent substrate 13. After being laminated on the transparent substrate 13, the adhesive film 14 is selectively irradiated with a light. The adhesive film 14 is left in the region surrounding region covering the plurality of light-receiving units 11 in the transparent substrate 13 when the transparent substrate 13 and the base substrate 12 are disposed facing each other. Then, base substrate 12 and the transparent substrate 13 are disposed facing each other and then bonded via the adhesive film 14. Furthermore, as in this embodiment, the base substrate 12 and the transparent substrate 13 which have been bonded are divided per a light-receiving unit.

### EXAMPLES

### (Example 1)

### 1. Synthesis of an alkali-soluble resin ( (meth) acrylic-modified bis-A novolac resin)

In a 2 liter flask, 500 g of a solution of a novolac type bisphenol-A resin (Phenolite LF-4871, manufactured by Dainippon Ink And Chemicals, Incorporated) in MEK (methyl ethyl ketone) (solid content: 60 %) was placed, followed by adding 1.5 g of tributylamine as a catalyst and 0.15 g of hydroquinone as a polymerization inhibitor to heat at 100°C. To the mixture, 180.9 g of glycidyl methacrylate was added dropwise over 30 min, and the mixture was reacted with stirring at 100 degrees C for 5 hours to give 74 % methacryloyl-modified novolac type bisphenol-A resin MPN001 (methacryloyl modification rate: 50 %, "Methacryl-modified bis-A novolac resin" in Tables 1 and 2) with a solid content of 74 %.

### 2. Preparation of an adhesive varnish

15 % by weight of trimethylolpropane trimethacrylate (manufactured by Kyoeisha Chemical Co., Ltd., Light-Ester TMP) as a photopolymerizable resin, 5 % by weight of a bisphenol-A novolac type epoxy resin (manufactured by Dainippon Ink And Chemicals, Incorporated, Epiclon N-865), 10 % by weight of a bisphenol-A type epoxy resin (manufactured by Japan Epoxy Resin Co., Ltd., Ep-828), 5 % by weight of a silicone epoxy resin (manufactured by Dow Corning Toray Silicone Co., Ltd., BY16-115, "Epoxy-modified siloxane" in Tables 1 and 2) as an epoxy resin as a thermosetting resin, 60 % by weight (solid content) of the (meth)acrylic-modified bis-A novolac resin prepared above as an alkali-soluble resin, 2 % by weight of a photopolymerization initiator (manufactured by Ciba Specialty Chemicals Inc., Irgacure 651) and 3 % by weight of a phenol novolac resin (manufactured by Sumitomo Bakelite Co., Ltd. , PR53647) were weighed and stirred at a rotating speed of 3000 rpm for one hour using a disperser to prepare a resin varnish.

### 3. Preparation of an adhesive film

A resin varnish was applied to a PET film (manufactured by Mitsubishi Plastics, Inc., MRX50, thickness: 50 µm) as a supporting substrate by a comma coater and dried at 80 degrees C for 20 min to give an adhesive film with a thickness of 50 µm.

### (Example 2)

The procedures in Example 1 were conducted except a composition of an adhesive varnish of Example 1 was as described below. A content of trimethylolpropane trimethacrylate was 5 % by weight and a content of the (meth) acrylic-modified bis-A novolac resin was 70 % by weight as a solid.

### (Example 3)

The procedures in Example 1 were conducted except a composition of an adhesive varnish of Example 1 was as described below. A content of trimethylolpropane trimethacrylate was 25 % by weight and a content of the (meth) acrylic-modified bis-A novolac resin was 50 % by weight as a solid.

### (Example 4)

The procedures in Example 1 were conducted except a composition of an adhesive varnish of Example 1 was as described below. A bisphenol-A type epoxy resin (manufactured by Japan Epoxy Resin Co. , Ltd., YL6810) was substituted for the bisphenol-A type epoxy resin (manufactured by Japan Epoxy Resin Co., Ltd., Ep-828).

### (Example 5)

The procedures in Example 1 were conducted except a composition of an adhesive varnish of Example 1 was as described below. Pentaerythritol triacrylate (manufactured by Kyoeisha Chemical Co., Ltd., Light Ester PE-3A) was substituted for trimethylolpropane trimethacrylate (manufactured by Kyoeisha Chemical Co., Ltd., Light Ester TMP).

### (Example 6)

The procedures in Example 1 were conducted except a composition of an adhesive varnish of Example 1 was as described below. Pentaerythritol triacrylate (manufactured by Kyoeisha Chemical Co., Ltd., Light Ester PE-4A) was substituted for trimethylolpropane trimethacrylate (manufactured by Kyoeisha Chemical Co., Ltd., Light Ester TMP). A bisphenol-A type epoxy resin (manufactured by Japan Epoxy Resin Co. , Ltd. YL6810) was substituted for a bisphenol-A type epoxy resin (manufactured by Japan Epoxy Resin Co., Ltd., Ep-828).

### (Example 7)

The procedures in Example 1 were conducted except a composition of an adhesive varnish of Example 1 was as described below. As a photopolymerizable resin, 5 % by weight of an epoxy vinyl ester resin (manufactured by Kyoeisha Chemical Co., Ltd., epoxy ester 3002M) was added. A content of the (meth) acrylic-modified bis-A novolac resin was 55 % by weight as a solid.

### (Example 8)

The procedures in Example 1 were conducted except a composition of an adhesive varnish of Example 1 was as described below. As a photopolymerizable resin, 10 % by weight of an epoxy vinyl ester resin (manufactured by Kyoeisha Chemical Co. , Ltd., epoxy ester 3002M) was added. A content of the (meth) acrylic-modified bis-A novolac resin was 50 % by weight as a solid.

### (Example 9)

The procedures in Example 1 were conducted except a composition of an adhesive varnish of Example 1 was as described below. As a photopolymerizable resin, 15 % by weight of an epoxy vinyl ester resin (manufactured by Kyoeisha Chemical Co., Ltd., epoxy ester 3002M) was added. Contents of trimethylolpropane trimethacrylate and the (meth) acrylic-modified bis-A novolac resin were 10 % by weight and 50 % by weight as a solid, respectively.

### (Example 10)

The procedures in Example 1 were conducted except a composition of an adhesive varnish of Example 1 was as described below. As a photopolymerizable resin, 5 % by weight of an epoxy vinyl ester resin (manufactured by Kyoeisha Chemical Co., Ltd., epoxy ester 3000M) was added. A content of the (meth) acrylic-modified bis-A novolac resin was 55 % by weight as a solid.

### (Example 11)

The procedures in Example 1 were conducted except a composition of an adhesive varnish of Example 1 was as described below. A content of trimethylolpropane trimethacrylate was 20 % by weight, and as a photopolymerizable resin, 5 % by weight of an epoxy vinyl ester resin (manufactured by Kyoeisha Chemical Co., Ltd., epoxy ester 3002M) was further added. A content of the bisphenol-A novolac type epoxy resin was 30 % by weight, and a bisphenol-A type epoxy resin (manufactured by Japan Epoxy Resin Co., Ltd., Ep-828) was absent. A content of the (meth)acrylic-modified bis-A novolac resin was 35 % by weight as a solid.

### (Example 12)

The procedures in Example 1 were conducted except a composition of an adhesive varnish of Example 1 was as described below. A content of trimethylolpropane trimethacrylate was 20 % by weight, and as a photopolymerizable resin, 5 % by weight of an epoxy vinyl ester resin (manufactured by Kyoeisha Chemical Co., Ltd. , epoxy ester 3002M) was further added. A content of the bisphenol-A novolac type epoxy resin was 25 % by weight, and a bisphenol-A type epoxy resin (manufactured by Japan Epoxy Resin Co., Ltd., Ep-828) was absent. A content of the (meth)acrylic-modified bis-A novolac resin was 40 % by weight as a solid.

### (Example 13)

The procedures in Example 1 were conducted except a composition of an adhesive varnish of Example 1 was as described below. A content of the (meth) acrylic-modified bis-A novolac resin was 50 % by weight as a solid. A content of trimethylolpropane trimethacrylate was 13 % by weight, a content of the epoxy vinyl ester resin (manufactured by Kyoeisha Chemical Co., Ltd., epoxy ester 3002M) as a photopolymerizable resin was 5 % by weight, and a content of silica (manufactured by Admatechs Co., Ltd., SO-E5) as a filler was 7 % by weight.

### (Comparative Example 1)

The procedures in Example 1 were conducted except a composition of an adhesive varnish of Example 1 was as described below. 1, 9-Nonandiol dimethacrylate (manufacturedby Shin-Nakamura Chemical Co., Ltd., Light Ester 1, 9ND) was substituted for trimethylolpropane trimethacrylate (manufactured by Kyoeisha Chemical Co., Ltd., Light Ester TMP).

### (Comparative Example 2)

The procedures in Example 1 were conducted except a composition of an adhesive varnish of Example 1 was as described below. Trimethylolpropane trimethacrylate (manufactured by Kyoeisha Chemical Co., Ltd., Light-Ester TMP) was absent. As a filler, 15 % by weight of Silica (manufactured by Admatechs Co., Ltd., SO-E5) was used.

### (Comparative Example 3)

The procedures in Example 1 were conducted except a composition of an adhesive varnish of Example 1 was as described below. Trimethylolpropane trimethacrylate (manufactured by Kyoeisha Chemical Co., Ltd., Light-Ester TMP) was absent. A content of the (meth)acrylic-modified bis-A novolac resin was 40 % by weight. As a filler, 35 % by weight of silica (manufactured by Admatechs Co., Ltd., SO-E5) was used.

### (Comparative Example 4)

The procedures in Example 1 were conducted except a composition of an adhesive varnish of Example 1 was as described below. Trimethylolpropane trimethacrylate (manufactured by Kyoeisha Chemical Co., Ltd., Light-Ester TMP) was used in 10 % by weight. As a filler, 15 % by weight of silica (manufactured by Admatechs Co., Ltd., SO-E5) was used. A content of the (meth) acrylic-modified bis-A novolac resin was 50 % by weight as a solid.

Table 1 shows the compositions of an adhesive film in Examples 1 to 10 and Comparative Examples 1 to 4. Table 2 shows the compositions of an adhesive film in Examples 11 to 13.

### [Table 1]

**(Table 1)**

| Classification | Raw material name | Example | | | | | | | | | | Comparative Example | | | |
|---|---|---|---|---|---|---|---|---|---|---|---|---|---|---|---|
| | | 1 | 2 | 3 | 4 | 5 | 6 | 7 | 8 | 9 | 10 | 1 | 2 | 3 | 4 |
| Alkali-soluble resin | Methacryl-modified bis-A novolac resin | 60 | 70 | 50 | 60 | 60 | 60 | 55 | 50 | 50 | 55 | 60 | 60 | 40 | 50 |
| Photocurable resin | 1,9-Nonandiol dimethacrylate | | | | | | | | | | | 15 | | | |
| | Trimethylolpropane trimethacrylate | 15 | 5 | 25 | 15 | | | 15 | 15 | 10 | 15 | | | | 10 |
| | Pentaerythritol triacrylate 3A | | | | | 15 | | | | | | | | | |
| | Pentaerythritol tetraacrylate 4A | | | | | | 15 | | | | | | | | |
| | Epoxy ester 3002M | | | | | | | 5 | 10 | 15 | | | | | |
| | Epoxy ester 3000M | | | | | | | | | | 5 | | | | |
| Epoxy resin | Bisphenol-A novolac type epoxy resin | 5 | 5 | 5 | 5 | 5 | 5 | 5 | 5 | 5 | 5 | 5 | 5 | 5 | 5 |
| | Bisphenol-A type epoxy resin (EP-828) | 10 | 10 | 10 | | 10 | | 10 | 10 | 10 | 10 | 10 | 10 | 10 | 10 |
| | Bisphenol-A type epoxy resin (YL6810) | | | | 10 | | 10 | | | | | | | | |
| | Epoxy-modified siloxane | 5 | 5 | 5 | 5 | 5 | 5 | 5 | 5 | 5 | 5 | 5 | 5 | 5 | 5 |
| photopolymerization initiator | | 2 | 2 | 2 | 2 | 2 | 2 | 2 | 2 | 2 | 2 | 2 | 2 | 2 | 2 |
| Phenolic resin | Phenol novolac resin | 3 | 3 | 3 | 3 | 3 | 3 | 3 | 3 | 3 | 3 | 3 | 3 | 3 | 3 |
| Filler | Silica | | | | | | | | | | | | 15 | 35 | 15 |
| Total | | 100 | 100 | 100 | 100 | 100 | 100 | 100 | 100 | 100 | 100 | 100 | 100 | 100 | 100 |

### [Table 2]

**(Table 2)**

| Classification | Raw material name | Exmaple | | |
|---|---|---|---|---|
| | | 11 | 12 | 13 |
| Alkali-soluble resin | Methacryl-modified bis-A novolac resin | 35 | 40 | 50 |
| Photocurable resin | Trimethylolpropane trimethacrylate | 20 | 20 | 13 |
| | Epoxy ester 3002M | 5 | 5 | 5 |
| Epoxy resin | Bisphenol-A novolac type epoxy resin | 30 | 25 | 5 |
| | Bisphenol-A type epoxy resin (EP-828) | 0 | 0 | 10 |
| | Bisphenol-A type epoxy resin (YL6810) | 0 | 0 | 0 |
| | Epoxy-modified siloxane | 5 | 5 | 5 |
| Photopolymerization. initiator | - | 2 | 2 | 2 |
| Phenolic resin | Phenol novolac resin | 3 | 3 | 3 |
| Filler | Silica (SO-E5) | 0 | 0 | 7 |
| Total | | 100 | 100 | 100 |

The adhesive films prepared in the examples were evaluated as described below. The results are shown in Tables 3 and 4.

### (1) Elastic modulus

The adhesive film prepared in any of Examples 1 to 13 and Comparative Examples 1 to 4 was exposed by irradiation with a light having a wavelength of 365 nm at 700 mJ/cm². Next, the PET film peeled off from the adhesive film, and three sheets of the adhesive layers are laminated, and an elastic modulus at 80 degrees C was determined by measuring a storage elasticmodulus G' using a dynamic viscoelastic measuring apparatus Rheo Stress RS150 (HAAKE GmbH, measurement frequency: 1 Hz, gap distance: 100 µm, measurement temperature range: 2.5 to 200 °C, rate of temperature increase: 10 °C/min) . The results are shown in Tables 3 and 4.

### (2) Permeability

An adhesive film with a thickness of 25 µm was prepared, a permeability was determined using a UV-visible spectrophotometer (Model: UV -160A, Shimadzu Corporation) at a measurement wavelength of 200 to 1000 nm, and a permeability at a wavelength of 365 nm was recorded as a measured value. The results are shown in Tables 3 and 4.

### (3) Moisture permeability

Using a laminator set at 60 degrees C, adhesive films are laminated to prepare a film with a thickness of 100 µm. Using an exposure device, irradiated with a light at an exposure amount of 700 mJ/cm² (wavelength: 365 nm) and then cured at 180 degrees C for 2 hours. The obtained cured film was evaluated under the atmosphere of 40 degrees C/90 % in accordance with a moisture-permeable cup method (JIS Z0208) and a moisture permeability was determined. The results are shown in Tables 3 and 4.

### [Table 3]

**(Table 3)**

| Evaluation items | Exmaple | | | | | | | | | | Comparative Example | | | |
|---|---|---|---|---|---|---|---|---|---|---|---|---|---|---|
| | 1 | 2 | 3 | 4 | 5 | 6 | 7 | 8 | 9 | 10 | 1 | 2 | 3 | 4 |
| Elastic modulus (Pa) | 320 | 190 | 520 | 830 | 1200 | 1310 | 1020 | 910 | 780 | 890 | 80 | 5100 | 29000 | 7300 |
| Permeability (%) | 22.3 | 21.1 | 41.0 | 25.6 | 24.8 | 26.1 | 24.0 | 25.8 | 24.3 | 29.1 | 25.3 | 4.1 | 2.7 | 8.1 |
| Moisture permeability 40 °C/90 % (g/m² 24h) | 15.8 | 14.1 | 16.1 | 15.2 | 15.1 | 14.2 | 13.9 | 14.8 | 15.2 | 13.3 | 17.1 | 14.6 | 15.8 | 16.9 |

### [Table 4]

**(Table 4)**

| Evaluation items | Exmaple | | |
|---|---|---|---|
| | 11 | 12 | 13 |
| Elastic modulus (Pa) | 9510 | 8110 | 1380 |
| Permeability (%) | 25.1 | 23.9 | 21.8 |
| Moisture permeability 40 °C/90 %(g/m² · 24h) | 25.6 | 19.4 | 13.1 |

As seen from Tables 3 and 4, Examples 1 to 13 were excellent in any of an elastic modulus, permeability and moisture permeability of the adhesive film after curing.

Next, there will be described an example of an adhesion product obtained by bonding a base substrate and a transparent substrate via the above adhesive film.

To an 8-inch semiconductor wafer (base substrate) (thickness: 300 µm) was laminated an adhesive film obtained in any of Examples 1 to 13 or Comparative Examples 1 to 4 under the conditions of a roll laminator (roll temperature: 60 degrees C, speed: 0.3m/min, syringe pressure: 2.0 kgf/cm²), to provide a semiconductor wafer with an adhesive film. Then, a mask in the exposure device was aligned with the 8-inch semiconductor wafer with an adhesive film by a light having a wavelength of 600 nm. Subsequently, the product was irradiated with a light having a wavelength of 365 nm at 700 mJ/cm² to peal off the PET film. The product was developed using 2.38 % by weight TMAH (tetramethylammonium hydroxide) under the conditions of developer pressure: 0.3 MPa and time: 90 sec, to form a frame member made of an adhesive film as a 5 mm square with a width of 0.6 mm.
Then, on the substrate bonder (manufactured by SUSS MicroTech AG., SB8e) were set the above semiconductor wafer with the frame member and the 8-inch transparent substrate, and the 8-inch semiconductor wafer and the 8-inch transparent substrate were bonded under pressure and post-cured under the conditions of 150 degrees C and 90 min. The adhesion product of the 8-inch semiconductor wafer and the 8-inch transparent substrate thus obtained was diced into a predetermined size by a dicing saw, to give a light-receiving device.

The evaluation samples were evaluated as described below. The results are shown in Tables 5 and 6.

### (4) Shape retainability

The above evaluation samples were visually evaluated for flowability of the frame member (observed deformation) The symbols denote the followings:
O: No changes were observed in the size of the frame member before and after thermal compression.
X: The resin spacer considerably flowed after thermal compression and significant changes were observed in the size and the shape.

### (5) Undercut

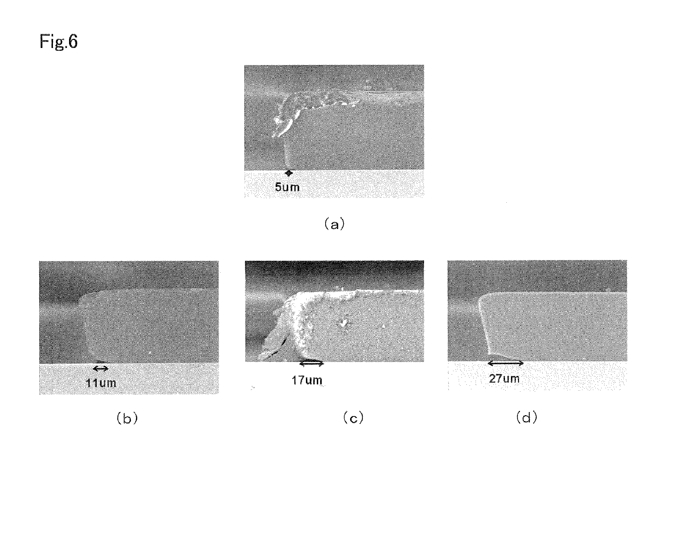

FIG. 6 shows the results of scanning microscopic observation of the cross-section of the frame member after exposure and development. In the adhesive film of Comparative Example 2, a 17 µm undercut was observed (FIG. 6(c)). Inaddition, in the adhesive film of Comparative Example 3, a 11 µm undercut was observed (FIG. 6(b)). Meanwhile, in the adhesive film of Example 1, a 5 µm undercut was observed (FIG. 6(a)). In Tables 5 and 6, undercuts of 5 µm or less are indicated by O, and undercuts of more than 5 µm are indicated by X.

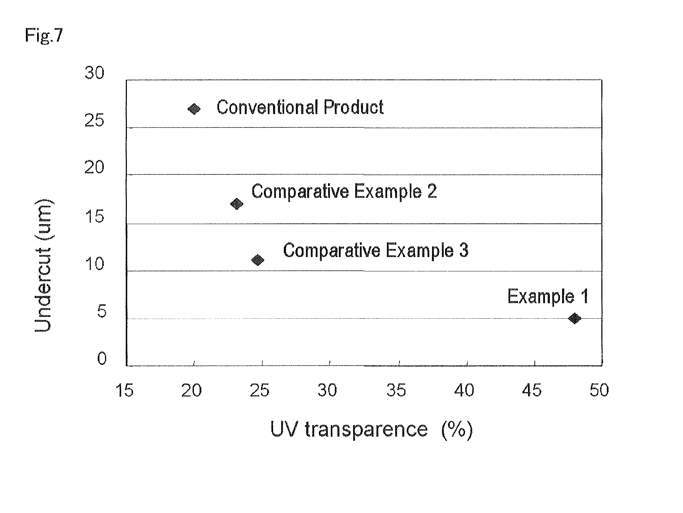

FIG. 6 (d) shows an undercut in the frame member of a similar evaluation sample prepared using a conventional adhesive film (hereinafter, referred to as a "conventional product"). In this sample, a 27 µm undercut was observed. FIG. 7 is a graph of a relationship between an undercut amount and a light transmission for the adhesive films of Example 1 and Comparative Examples 2 and 3, and the adhesive film of the conventional product. It indicates that as a light transmission increases, an undercut amount is reduced.

### (6) Residue

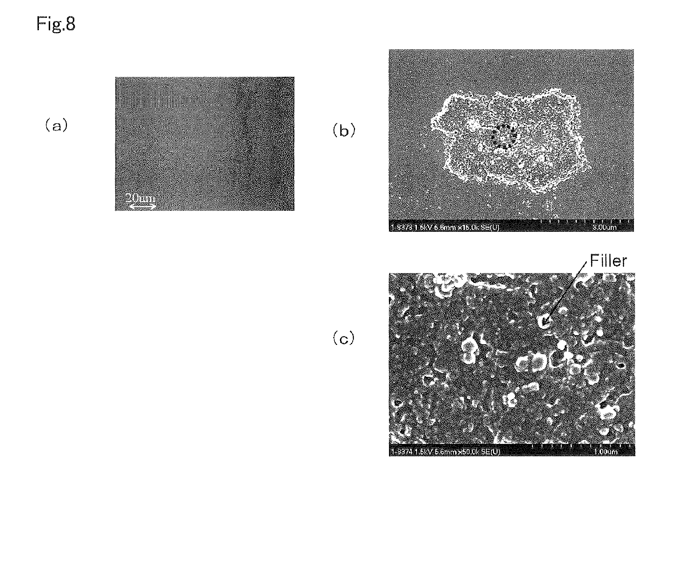

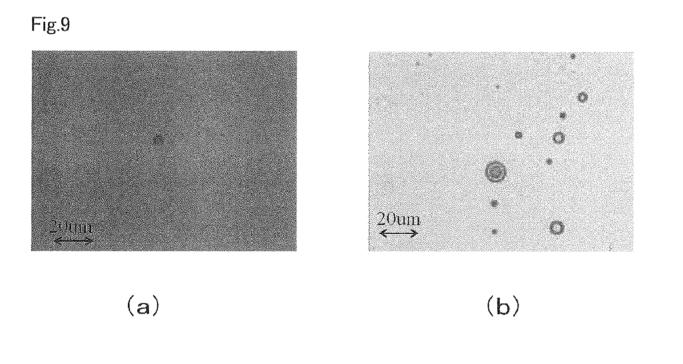

After exposure and development, the light-receiving unit was observed by scanning microscopy, and in the adhesive film of Comparative Example 2, foreign materials shown in FIG. 8 (a) (type A) and in FIG. 9 (a) (type B) were found on the wafer. When the type A foreign material shown in FIG. 8(a) was enlarged, a component derived from the resin composition was observed (FIG. 8 (b)). When the area enclosed by the dotted line in FIG. 8 (b) was enlarged, the silica filler was observed (FIG. 8(c)). The type B foreign material shown in FIG. 9(a) was a liquid (FIG. 9(a)). When the type B foreign material shown in FIG. 9(a) was enlarged, the silica filler was observed, but a component derived from the resin composition was not found (FIG. 9(b)). In the adhesive film of Comparative Example 1, the type A foreign material as shown in FIG. 8 was not observed, but the type B foreign material was found. In the adhesive material of any of Examples 1 to 13, neither the type A nor the type B foreign material is observed. In Tables 5 and 6, O indicates that a foreign material is absent, and X indicates that foreign materials are present, respectively on the base substrate or the transparent substrate.

### (7) Dew condensation

A sample was treated under the conditions of temperature: 60 degrees C and humidity: 90 % for 500 hours, and then exposed to an atmosphere of temperature: 25 degrees C and humidity: 50 %, and then the presence or absence of dew condensation on the inside of the glass substrate in the evaluation sample was observed. The results are shown in Tables 5 and 6. In Tables 5 and 6, O indicates the absence of dew condensation, and X indicates the presence of dew condensation.

### [Table 5]

**(Table 5)**

| Evaluation items | Exmaple | | | | | | | | | | Comparative Example | | | |
|---|---|---|---|---|---|---|---|---|---|---|---|---|---|---|
| | 1 | 2 | 3 | 4 | 5 | 6 | 7 | 8 | 9 | 10 | 1 | 2 | 3 | 4 |
| Shape retainability | ○ | ○ | ○ | ○ | ○ | ○ | ○ | ○ | ○ | ○ | × | ○ | ○ | ○ |
| Undercut | ○ | ○ | ○ | ○ | ○ | ○ | ○ | ○ | ○ | ○ | ○ | × | × | × |
| Residue | ○ | ○ | ○ | ○ | ○ | ○ | ○ | ○ | ○ | ○ | ○ | × | × | × |
| Dew condensation | ○ | ○ | ○ | ○ | ○ | ○ | ○ | ○ | ○ | ○ | ○ | ○ | ○ | ○ |

### [Table 6]

**(Table 6)**

| Evaluation items | Exmaple | | |
|---|---|---|---|
| | 11 | 12 | 13 |
| Shape retainability | ○ | ○ | ○ |
| Undercut | ○ | ○ | ○ |
| Residue | ○ | ○ | ○ |
| Dew condensation | ○ | ○ | ○ |

As seen from Tables 5 and 6, Examples 1 to 13 were excellent in shape retainability of the light-receiving device. Furthermore, undercut in the frame member was reduced. Furthermore, a residue or dew condensation was not observed on the wafer, demonstrating good reliability.

## Claims

1. A light-receiving device comprising:
at least one light-receiving unit;
a base substrate provided with said light-receiving unit;
a transparent substrate disposed facing said base substrate and said light-receiving unit; and
a frame member disposed around said light-receiving unit between said base substrate and said transparent substrate; wherein said frame member consists of a cured resin composition;
said resin composition contains
an alkali-soluble resin,
a photopolymerizable resin, and
an inorganic filler of 9 % or less by weight;
said photopolymerizable resin includes an acrylic polyfunctional monomer;
said frame member meets the following conditions (a) and (b):
(a) said frame member has a moisture permeability of 12 [g/m²·24h] or more as determined in accordance with JIS Z0208 Method B; and
(b) said frame member has an elastic modulus of 100 Pa or more at 80 degrees C after exposure at all wavelengths by a mercury lamp until an accumulated exposure amount is 700 mJ/cm² with an i-line (365 nm) beam.

2. The light-receiving device according to Claim 1, wherein said photopolymerizable resin includes an epoxy vinyl ester resin.

3. The light-receiving device according to Claim 2, wherein a weight content of said epoxy vinyl ester resin is 3 to 30 % of said resin composition.

4. The light-receiving device according to any one of Claims 1 to 3, wherein said acrylic polyfunctional monomer is a (meth) acrylate compound.

5. The light-receiving device according to any one of Claims 1 to 4, wherein said acrylic polyfunctional monomer is a trifunctional (meth)acrylate compound or a tetrafunctional(meth)acrylate compound.

6. The light-receiving device according to any one of Claims 1 to 5, wherein said acrylic polyfunctional monomer is trimethylolpropane tri(meth)acrylate.

7. The light-receiving device according to any one of Claims 1 to 6, wherein a weight content of said acrylic polyfunctional monomer is 1 to 50 % of said resin composition.

8. The light-receiving device according to any one of Claims 1 to 7, wherein said alkali-soluble resin is a (meth) acrylic-modified novolac resin.

9. The light-receiving device according to any one of Claims 1 to 8, wherein a weight content of said alkali-soluble resin is 50 to 95 % of said resin composition.

10. A method for manufacturing a light-receiving device, comprising:
laminating an adhesive film composed of an electron-beam curable resin composition on a base substrate provided with at least one light-receiving unit or a transparent substrate to cover said base substrate or said transparent substrate;
selectively irradiating said adhesive film with an electron beam to leave said adhesive film in a region surrounding at least said light-receiving unit on said base substrate or a region surrounding each region covering said light-receiving unit in said transparent substrate when said transparent substrate is disposed facing said base substrate;
disposing said base substrate and said transparent substrate facing each other to bond via said adhesive film; and
providing a light-receiving device having said base substrate, said transparent substrate, and a frame member which is composed of said adhesive film to be disposed around said light-receiving unit while being provided between said base substrate and said transparent substrate;
wherein
said resin composition contains
an alkali-soluble resin,
a photopolymerizable resin, and
an inorganic filler 9 % or less by weight;
said photopolymerizable resin incrudes an acrylic polyfunctional monomer;
said frame member meets the following conditions (a) and (b):
(a) said frame member has a moisture permeability of 12 [g/m²·24h] or more as determined in accordance with JIS Z0208 Method B; and
(b) said frame member has an elastic modulus of 100 Pa or more at 80 degrees C after exposure at all wavelengths by a mercury lamp until an accumulated exposure amount is 700 mJ/cm² with an i-line (365 nm) beam.

11. The method for manufacturing a light-receiving device according to Claim 10, wherein said photopolymerizable resin incrudes an epoxy vinyl ester resin.
